# EUROPEAN PATENT APPLICATION

(11) **EP 4 467 682 A1**
(43) Date of publication of application: **27.11.2024**
(21) Application number: 23906327.4
(22) Date of filing: 04.07.2023
(51) Int. Cl.: C23C 16/42, C30B 29/36, H01L 21/205

(54) **POLYCRYSTALLINE SIC MOLDED ARTICLE, AND METHOD FOR PRODUCING SAME**

(30) Priority: 22.12.2022 JP 2022205441
(71) Applicant: Tokai Carbon Co., Ltd., Minato-ku Tokyo 107-8636 (JP)
(72) Inventor: SUGIHARA, Takaomi, Tokyo 107-8636 (JP)
(74) Representative: Eisenführ Speiser
(86) International application number: PCT/JP2023/024819
(87) International publication number: WO 2024/134941

(57) **Abstract**

The present invention provides a polycrystalline SiC formed body excellent in flatness, and a method for manufacturing the same; it is a substantially plate-shaped polycrystalline SiC formed body comprising a first main surface and a parallel second main surface, the polycrystalline SiC formed body including, along a normal direction to the first main surface, a region R₂₀₀, a region R₃₁₁, a region R₁₁₁, and a region R₂₂₀ in which a (200) plane, a (311) plane, a (111) plane, and a (220) plane are oriented, respectively; and along a normal direction to the second main surface, a region R₂₀₀, a region R₃₁₁, a region R₁₁₁, and a region R₂₂₀ in which a (200) plane, a (311) plane, a (111) plane, and a (220) plane are oriented, respectively, wherein an area fraction of region R_{XYZ}=area of region R_{XYZ}/(area of region R₁₁₁+area of region R₂₀₀+area of region R₂₂₀+area of region R₃₁₁) and region R_{XYZ} is any one of region R₁₁₁, region R₂₀₀, region R₂₂₀, and region R₃₁₁, wherein at least one of a difference between an area fraction of region R₂₀₀ in the first main surface and an area fraction of region R₂₀₀ in the second main surface being 10.0% or less and a difference between an area fraction of region R₃₁₁ in the first main surface and an area fraction of region R₃₁₁ in the second main surface being 10.0% or less is satisfied.

## Description

### Technical Field

The present invention relates to a polycrystalline SiC formed body and a method for manufacturing the same.

### Background Art

SiC formed bodies are excellent in various properties such as heat resistance, corrosion resistance, and strength, and are used in various applications. For example, Patent Literatures 1 and 2 describe the use of SiC formed bodies as members for plasma etching apparatuses, such as edge rings, electrode plates, and heaters, used in semiconductor manufacturing.

### Citation List

### Patent Literatures

Patent Literature 1: Japanese Patent Application Publication No. 2001-316821
Patent Literature 2: Japanese Patent Application Publication No. 2001-220237

### Summary of Invention

### Problems to be solved by the invention

There are cases where a polycrystalline SiC formed body is required to have high flatness. For example, as described in Patent Literatures 1 and 2, when a polycrystalline SiC formed body is used as a member for plasma etching, the polycrystalline SiC formed body used as a member for a plasma etching apparatus is required to have a flat surface so that the object to be processed is uniformly processed by plasma.

In light of the above, an object of the present invention is to provide a polycrystalline SiC formed body excellent in flatness, and a method for manufacturing the same.

### Means for solution of the problems

The present inventors have found that in a plate-shaped polycrystalline SiC formed body, the difference in area fraction of a region where crystal planes in a specific orientation are oriented between a first main surface and a second main surface parallel to the first main surface is related to the flatness of the polycrystalline SiC formed body; thus, the present invention has been completed. That is, the present invention is achieved by the following matters.
<1> A substantially plate-shaped polycrystalline SiC formed body comprising a first main surface and a second main surface parallel to the first main surface,
   the polycrystalline SiC formed body including:
   along a normal direction to the first main surface,
      a region R₂₀₀ in which a (200) plane is oriented,
      a region R₃₁₁ in which a (311) plane is oriented,
      a region R₁₁₁ in which a (111) plane is oriented, and
      a region R₂₂₀ in which a (220) plane is oriented, and
   along a normal direction to the second main surface,
      a region R₂₀₀ in which a (200) plane is oriented,
      a region R₃₁₁ in which a (311) plane is oriented,
      a region R₁₁₁ in which a (111) plane is oriented, and
      a region R₂₂₀ in which a (220) plane is oriented,
   wherein an area fraction of region R_{XYZ}=area of region R_{XYZ}/(area of region R₁₁₁+area of region R₂₀₀+area of region R₂₂₀+area of region R₃₁₁) and region R_{XYZ} is any one of region R₁₁₁, region R₂₀₀, region R₂₂₀, and region R₃₁₁, wherein at least one of a difference between an area fraction of region R₂₀₀ in the first main surface and an area fraction of region R₂₀₀ in the second main surface being 10.0% or less and a difference between an area fraction of region R₃₁₁ in the first main surface and an area fraction of region R₃₁₁ in the second main surface being 10.0% or less is satisfied.
<2> The polycrystalline SiC formed body according to <1>, wherein at least one of a difference between an area fraction of region R₁₁₁ in the first main surface and an area fraction of region R₁₁₁ in the second main surface being 2.0% or less, and a difference between an area fraction of region R₂₂₀ in the first main surface and an area fraction of region R₂₂₀ in the second main surface being 2.0% or less is satisfied.
<3> The polycrystalline SiC formed body according to <1> or <2>, wherein an absolute value of BOW is 30 µm or less.
<4> A method of producing the polycrystalline SiC formed body according to any one of <1> to <3>, the method comprising forming a polycrystalline SiC layer on a substrate by a CVD method, wherein in forming the polycrystalline SiC layer, crystal growth is controlled so that at least one of a difference in area fraction of the region R₂₀₀ and a difference in area fraction of the region R₃₁₁ between the second main surface in the polycrystalline SiC layer and the first main surface in the polycrystalline SiC layer becomes 10.0% or less.

### Advantageous Effects of Invention

According to the present invention, it is possible to provide a polycrystalline SiC formed body excellent in flatness, and a method for manufacturing the same.

### Brief Description of Drawings

Fig. 1 shows an example of an EBSD orientation map of a polycrystalline SiC formed body measured by the EBSD method.
Fig. 2 shows a schematic diagram of an EBSD orientation map of a polycrystalline SiC formed body.

### Description of Embodiments

Hereinafter, embodiments of the present invention will be described in detail. The following detailed description of the present invention is an example of an embodiment, and the present invention is not limited to this embodiment.

A polycrystalline SiC formed body according to the present embodiment has a first main surface and a second main surface parallel to the first main surface, and has a plate shape. The first main surface and the second main surface are surfaces parallel to the surface of the substrate in CVD. The polycrystalline SiC formed body satisfies at least one of a difference between an area fraction of region R₂₀₀ in the first main surface and an area fraction of region R₂₀₀ in the second main surface being 10.0% or less and a difference between an area fraction of region R₃₁₁ in the first main surface and an area fraction of region R₃₁₁ in the second main surface being 10.0% or less.

The difference in area fraction of region R₂₀₀ is represented by a "difference" between an "area fraction of region R₂₀₀ in the first main surface" and an "area fraction of region R₂₀₀ in the second main surface."

The difference in area fraction of region R₃₁₁ is represented by a "difference" between an "area fraction of region R₃₁₁ in the first main surface" and an "area fraction of region R₃₁₁ in the second main surface."

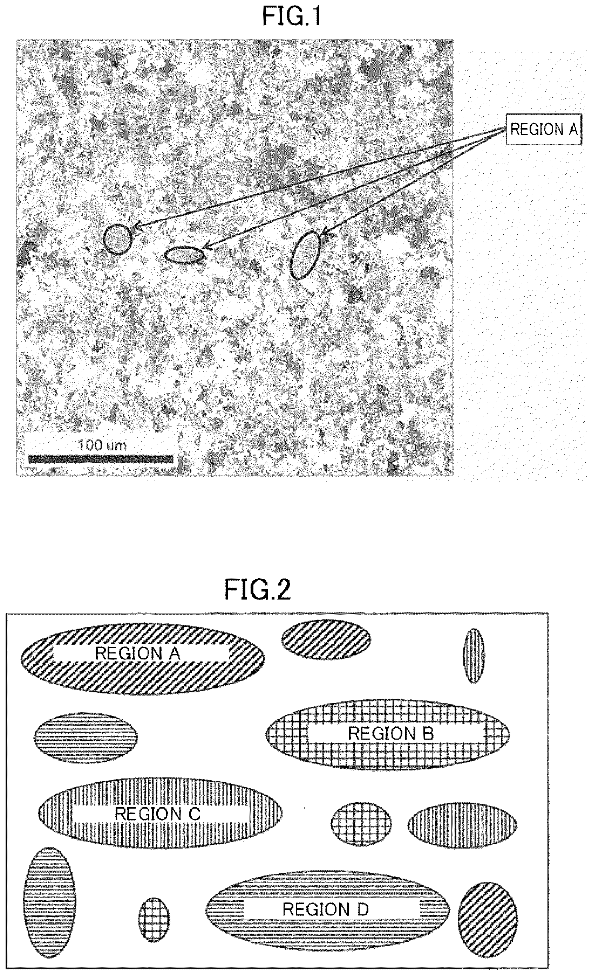

Here, the "area fraction of a region" refers to the degree of orientation of a specific crystal plane. Specifically, the "area fraction of a region" is as follows. In the present specification, the "area fraction of a region" is a value calculated from the size of a region observed as the same orientation by an EBSD (Electron Backscatter Diffraction) method. Fig. 1 shows an example of an EBSD orientation map of a polycrystalline SiC formed body measured by the EBSD method. Here, the "same orientation" means a region having the same crystal structure and the same orientation with respect to the first main surface or the second main surface. Regions with the same orientation are displayed with the same pattern in the EBSD orientation map. Fig. 2 shows a schematic diagram of an EBSD orientation map of a polycrystalline SiC formed body.

Specifically, an "area fraction" of a region A indicating a specific orientation refers to a value obtained by dividing a total area (SA) of the region A indicating the same orientation by a sum (SA+SB+SC+SD...) of areas of all observed orientations (A, B, C, D...) within the entire region observed by the EBSD method.

SA is the total area of regions measured as the same orientation with the region A in the same pattern.

SB is the total area of regions measured as the same orientation with the region B in the same pattern.

SC is the total area of regions measured as the same orientation with the region C in the same pattern.

SD is the total area of regions measured as the same orientation with the region D in the same pattern.

Here, the measurement area of the entire region is appropriately adjusted to a square and a rectangle in a region from 100 µm×100 µm to 500 µm×500 µm. By setting the measurement area to a region of 500 µm×500 µm or less, the total number of pixels in the region indicating the orientation of a specific crystal plane can be increased, so that measurement accuracy is improved. By setting the measurement area to a region of 100 µm×100 µm or more, the resolution of the entire measurement area can be maintained, so that measurement accuracy is improved.

The "difference in area fraction" of the region A refers to a difference between an "area fraction" of the region A of the first main surface and an "area fraction" of the region A of the second main surface.

The area fraction of a region indicating a specific orientation can be measured by a method described in Examples below.

According to the findings of the present inventors, warpage of the SiC formed body is suppressed by setting at least one of the difference in area fraction of the region R₂₀₀ and the difference in area fraction of the region R₃₁₁ to 10.0% or less. That is, a polycrystalline SiC formed body with high flatness is achieved.

There are various factors that cause warpage of a polycrystalline SiC formed body, one of which is that internal stress exists in the polycrystalline SiC formed body, so that the polycrystalline SiC formed body is deformed by the internal stress after being flattened.

There are various factors that cause internal stress; however, the inventors have found that one of the factors is that the area fraction of a region indicating a specific orientation of the first main surface is different from the area fraction of a region indicating a specific orientation of the second main surface, and as the difference is larger, the internal stress is larger, so that warpage occurs.

The polycrystalline SiC formed body becomes thicker as the polycrystalline SiC is deposited from the substrate surface; however, in this process, when the area fractions of the regions indicating specific orientations become different, compressive stress and tensile stress due to the change in orientation are generated. The greater the change in the area fraction of the region indicating the specific orientation, the greater the generated compressive stress and tensile stress, the greater the finally generated internal stress, and as a result, the greater the degree of warpage generated.

The polycrystalline SiC formed body satisfies at least one of a difference in area fraction of region R₁₁₁ being 2.0% or less and a difference in area fraction of region R₂₂₀ being 2.0% or less.

The difference in area fraction of region R₁₁₁ is represented by a "difference" between an "area fraction of region R₁₁₁ in the first main surface" and an "area fraction of region R₁₁₁ in the second main surface."

Similarly, the difference in area fraction of region R₂₂₀ is represented by a "difference" between an "area fraction of region R₂₂₀ in the first main surface" and an "area fraction of region R₂₂₀ in the second main surface."

Preferably, the polycrystalline SiC formed body is disk-shaped. Preferably, the polycrystalline SiC formed body is disk-shaped with a diameter of 1.5 to 12 inches, more preferably 4 to 9 inches. A diameter of 1.5 inches or more is preferable because a processed body that can be used for many applications can be processed, and a diameter of 12 inches or less is preferable because physical properties of the entire formed body become uniform.

Preferably, the thickness of the polycrystalline SiC formed body is 0.10 mm to 7.00 mm. More preferably, the thickness is 0.15 mm to 5.00 mm, and further preferably 0.30 mm to 3.00 mm. The thickness is preferably 0.10 mm or more because a polycrystalline SiC formed body that is easy to handle can be obtained, such as reduction of breakage during processing, and 7.00 mm or less because generation of cracks and the like can be prevented.

Preferably, the polycrystalline SiC formed body has a resistivity of 0.050 Ωcm or less, preferably 0.020 Ωcm or less, more preferably 0.005 Ωcm or less.

By having such a resistivity, the polycrystalline SiC formed body can be suitably used in applications requiring high conductivity.

The resistivity can be adjusted, for example, by doping the polycrystalline SiC formed body with nitrogen. The doping amount of nitrogen in the polycrystalline SiC formed body is, for example, 200 ppm (2.8×10¹⁹ atoms/cm³) or more, preferably 400 ppm (5.6×10¹⁹ atoms/cm³) or more, more preferably 1450 ppm (2.0×10²⁰ atoms/cm³) or more.

As described above, the present embodiment satisfies at least one of a difference between the area fraction of the region R₂₀₀ of the first main surface and the area fraction of the region R₂₀₀ of the second main surface being 10.0% or less, and a difference between the area fraction of the region R₃₁₁ of the first main surface and the area fraction of the region R₃₁₁ of the second main surface being 10.0% or less; therefore, it is possible to reduce warpage of the polycrystalline SiC formed body.

Specifically, according to the present embodiment, when the polycrystalline SiC formed body is disk-shaped, a BOW with an absolute value of 30 µm or less can be achieved.

BOW is a known parameter representing the flatness of a disk-shaped substrate such as a silicon wafer. Hereinafter, BOW will be described.

BOW represents a distance between a plane (referred to as a three-point reference plane) passing through three points set on a main surface of a polycrystalline SiC formed body substrate and a center point of the main surface of the polycrystalline SiC formed body substrate. Three points set to determine the three-point reference plane are set at positions to form an equilateral triangle centered on the center of the main surface. Further, these three points are set at positions about 3% of the diameter inward from the outer peripheral edge of the polycrystalline SiC substrate.

More specifically, the BOW value can be measured by FlatMaster 200 manufactured by Tropel Corporation.

### (Manufacturing Method)

Next, an example of a method for manufacturing the polycrystalline SiC formed body according to the present embodiment will be described.

The polycrystalline SiC formed body according to the present embodiment can be obtained, for example, by forming a polycrystalline SiC layer on a substrate by a CVD method.

Specifically, first, a graphite substrate or the like is placed as a substrate in a CVD furnace.

Then, a carrier gas, a source gas to be a source of SiC, and a nitrogen-containing gas are mixed, and the mixed gas is supplied to the CVD furnace. Thereby, a polycrystalline SiC layer is formed on the substrate. Further, nitrogen derived from the nitrogen-containing gas is doped into the polycrystalline SiC layer.

After the film formation, the resulting polycrystalline SiC layer is separated from the substrate. Further, the polycrystalline SiC layer is ground. As a result, a polycrystalline SiC formed body is obtained.

Here, when forming the polycrystalline SiC layer, crystal growth is controlled so that at least one of a difference in area fraction of the region R₂₀₀ and a difference in area fraction of the region R₃₁₁ between the substrate-side surface (for example, the second main surface) in the polycrystalline SiC layer and the growth surface (for example, the first main surface) in the polycrystalline SiC layer becomes 10.0% or less.

Specifically, at least one of the difference in area fraction of the region R₂₀₀ and the difference in area fraction of the region R₃₁₁ can be reduced to 10.0% or less by forming at a deposition temperature of preferably 1100°C to 1900°C, more preferably 1200°C to 1600°C, setting a residence time to 20 to 45 seconds, controlling a positional relationship between a substrate and a gas nozzle so that a gas injection angle with respect to a substrate plane is 5° to 55°, and setting a nitrogen partial pressure to 10.0% to 60%.

The carrier gas used for the film formation is not particularly limited; for example, hydrogen gas or the like can be used.

The source gas is not particularly limited as long as it is a gas containing sources of Si and C. For example, a gas containing Si and C in a molecule, a mixed gas of a gas containing Si in a molecule and a hydrocarbon gas, or the like can be used.

Examples of the source gas include, in the case of a one-component system, trichloromethylsilane, trichlorophenylsilane, dichloromethylsilane, dichlorodimethylsilane, chlorotrimethylsilane, and the like. In the case of a two-component system, examples thereof include a mixture of a silane-containing gas such as trichlorosilane and monosilane, and a hydrocarbon gas.

The growth surface side of the polycrystalline SiC formed body immediately after being formed, which is obtained by separating the resulting polycrystalline SiC formed body layer from the substrate after the film formation, has irregularities, and a part of the separated substrate adheres to the substrate surface side. Since these residues affect warpage, the growth surface side and the substrate surface side of the polycrystalline SiC formed body are appropriately ground to remove the irregularities and the residual substrate portion. The grinding amount on the growth surface side and the grinding amount on the substrate surface side are appropriately adjusted to 20 µm or more based on the degree of unevenness, the degree of the residual substrate portion, the thickness of the polycrystalline SiC formed body before grinding, the thickness of the polycrystalline SiC formed body required after grinding, and the like.

As described above, according to the present embodiment, since at least one of the difference in area fraction of the region R₂₀₀ and the difference in area fraction of the region R₃₁₁ is controlled to be 10.0% or less, warpage of the polycrystalline SiC formed body can be reduced. Specifically, when the polycrystalline SiC formed body is disk-shaped, a BOW with an absolute value of 30 µm or less can be achieved.

The polycrystalline SiC formed body according to the present embodiment is suitably used for applications requiring flatness. For example, such an application is a support substrate for supporting a single crystal SiC layer. Alternatively, the polycrystalline SiC formed body is suitably used as a member for a plasma etching apparatus used in semiconductor manufacturing. Examples of such a member for a plasma etching apparatus include an edge ring, an electrode plate, and a heater. The polycrystalline SiC formed body can also be used as a dummy wafer used as a member for a semiconductor heat treatment apparatus during semiconductor manufacturing.

### Examples

Hereinafter, in order to describe the present invention in more detail, Examples conducted by the present inventors will be described. However, the present invention should not be construed as being limited to the following Examples.

### (Example 1)

A graphite substrate having a diameter of 160 mm and a thickness of 5 mm was placed in a CVD furnace. Trichloromethylsilane (source gas), hydrogen (carrier gas), and nitrogen gas were introduced into the CVD furnace, and a polycrystalline SiC film was formed on the graphite substrate at 1400°C for 10 hours.

The film forming conditions are shown in Table 1.

The gas residence time was 35 (seconds). The gas residence time was calculated by the following formula. Gas residence time (seconds)=(furnace internal volume/gas flow rate)×((20+273)/(reaction temperature+273))×60

After the film formation, the graphite substrate was taken out of the CVD furnace, and subjected to outer peripheral processing and dividing processing. Further, the graphite substrate was removed to obtain a polycrystalline SiC formed body having a diameter of 150 mm and a thickness of 0.6 mm. Further, the first main surface and the second main surface were subjected to grinding processing by surface grinding processing to obtain a polycrystalline SiC formed body having a diameter of 150 mm and a thickness of 0.4 mm. This was obtained as a polycrystalline SiC formed body according to Example 1.

### (Examples 2 to 6 and Comparative Examples 1 and 2)

SiC formed bodies were obtained in the same manner as in Example 1, except that the conditions were changed as described in Table 1.

### (Measurement of Resistivity)

The volume resistivity of the polycrystalline SiC formed body was measured by a four-probe method. A "Loresta-GP MCT-T610" (manufactured by Mitsubishi Chemical Analytech Co., Ltd.) was used as a measuring device.

Specifically, a probe of the measuring device was brought into contact with the first surface of the polycrystalline SiC formed body to measure the volume resistivity. The results are shown in Table 2.

### (Measurement of Nitrogen Concentration)

The nitrogen concentration in the polycrystalline SiC formed body was measured by secondary ion mass spectrometry. A "SIMS-4000" (manufactured by ATOMIKA) was used as a measuring device. The results are shown in Table 2.

### (Measurement of Difference in Area Fraction)

The difference in area fraction of the region R₂₀₀, the difference in area fraction of the region R₃₁₁, the difference in area fraction of the region R₁₁₁, and the difference in area fraction of the region R₂₂₀ were measured for the resulting polycrystalline SiC formed bodies according to Examples 1 to 6 and Comparative Examples 1 and 2 by the following method. The difference in area fraction of each crystal plane region was calculated from a "difference" between an "area fraction of each crystal plane region on the first main surface" and an "area fraction of each crystal region on the second main surface." The results are shown in Table 3.

### (Measurement of Area Fraction of Each Crystal Plane Region)

EBSD orientation maps were measured for the main surface normal direction±15° direction (hereinafter referred to as ND direction) of the polycrystalline SiC formed bodies obtained in Examples 1 to 6 and Comparative Examples 1 and 2 using DigiView manufactured by TSL Solutions Co., Ltd.

The area of the region R₁₁₁ where the (111) plane of 3C-type crystal structure SiC is oriented along the ND direction was extracted as S (111) from the EBSD orientation map. Similarly, the area of the region R₂₀₀ of the (200) plane, the area of the region R₂₂₀ of the (220) plane, or the area of the region R₃₁₁ of the (311) plane was also extracted as S (200), S (220), or S (311). Based on the extraction results, the area fraction of each crystal plane region in the measurement region of 300 µm×300 µm was determined by the following calculation. Area fraction of each crystal plane region=Area of each crystal plane region/(S (111)+S (200)+S (220)+S (311))

The measurement conditions of the EBSD orientation map were as follows.
Pretreatment: Mechanical polishing, carbon deposition
Apparatus:
   FE-SEM SU-70 manufactured by Hitachi High-Tech Corporation
   EBSD DigiView manufactured by TSL Solutions Co., Ltd.
Measurement conditions:
   Voltage: 20 kV
   Inclination angle: 70°
   Measurement area: 300 µm×300 µm
   Measurement interval: 0.35 µm
   Evaluation target crystal system: 3C-type SiC (space group 216)

### (Measurement of BOW)

BOW represents a distance between a plane (referred to as a three-point reference plane) passing through three points set on a main surface of a polycrystalline SiC substrate and a center point of the main surface of the polycrystalline SiC substrate. Three points set to determine the three-point reference plane are set at positions to form an equilateral triangle centered on the center of the main surface. Further, these three points are set at positions about 3% of the diameter inward from the outer peripheral edge of the polycrystalline SiC substrate.

More specifically, the BOW value can be measured by FlatMaster 200 manufactured by Tropel Corporation. The absolute values of the BOW values obtained by the measurement are shown in Table 3.

In Table 3, (111)/Total, (200)/Total, (220)/Total, and (311)/Total represent a difference in area fraction of region R₁₁₁, a difference in area fraction of region R₂₀₀, a difference in area fraction of region R₂₂₀, and a difference in area fraction of region R₃₁₁, respectively.

As shown in Table 3, there was a clear correlation between the difference in area fraction of the region R₂₀₀, the difference in area fraction of the region R₃₁₁, and the BOW. When at least one of the difference in area fraction of region R₂₀₀ and the difference in area fraction of region R₃₁₁ was within a range of 10.0% or less, a small BOW with an absolute value of 30 µm or less was obtained.

On the other hand, regarding the difference in area fraction of region R₁₁₁ and the difference in area fraction of region R₂₂₀, when at least one of them was within a range of 2.0% or less, a small BOW with an absolute value of 30 µm or less was obtained.

**Table 1**

| | Reaction Temperature (°C) | Gas Flow Rate (L/min) | | | | N₂ Partial Pressure (%) | Reaction Furnace Internal Volume (L) | Gas Residence Time (sec) | Gas Injection Angle with Respect to Substrate Plane (°) |
|---|---|---|---|---|---|---|---|---|---|
| | | Source | H₂ | N₂ | Total Flow Rate | | | | |
| Example 1 | 1400 | 14 | 126 | 70 | 210 | 33 | 700 | 35 | 5 |
| Example 2 | 1400 | 14 | 126 | 140 | 280 | 50 | 700 | 26 | 8 |
| Example 3 | 1400 | 14 | 126 | 31 | 171 | 18 | 700 | 43 | 10 |
| Example 4 | 1400 | 14 | 126 | 39 | 179 | 22 | 700 | 41 | 15 |
| Example 5 | 1400 | 14 | 126 | 52 | 192 | 27 | 700 | 38 | 47 |
| Example 6 | 1400 | 14 | 126 | 101 | 241 | 42 | 700 | 31 | 35 |
| Comparative Example 1 | 1400 | 14 | 126 | 280 | 420 | 67 | 700 | 18 | 70 |
| Comparative Example 2 | 1400 | 14 | 126 | 11 | 151 | 7 | 700 | 48 | 60 |

**Table 2**

| | Resistivity (Ω·cm) | Nitrogen Concentration (ppm) |
|---|---|---|
| Example 1 | 0.005 | 930 |
| Example 2 | 0.002 | 1550 |
| Example 3 | 0.020 | 298 |
| Example 4 | 0.010 | 524 |
| Example 5 | 0.007 | 680 |
| Example 6 | 0.003 | 1145 |
| Comparative Example 1 | 0.001 | 2350 |
| Comparative Example 2 | 0.100 | 140 |

**Table 3**

| | Absolute Value of BOW Value (µm) | Difference in Area Fraction | | | | Gas Injection Angle with Respect to Substrate Plane (°) |
|---|---|---|---|---|---|---|
| | | (200)/Total | (311)/Total | (111)/Total | (220)/Total | |
| Example 1 | 10.1 | 3.2% | 2.9% | 0.1% | 0.2% | 5 |
| Example 2 | 15.7 | 6.9% | 6.5% | 0.1% | 0.2% | 8 |
| Example 3 | 18.3 | 9.0% | 11.0% | 3.5% | 1.5% | 10 |
| Example 4 | 22.0 | 7.5% | 13.0% | 2.2% | 0.8% | 15 |
| Example 5 | 20.1 | 13.2% | 8.0% | 1.0% | 3.5% | 47 |
| Example 6 | 23.2 | 13.0% | 10.0% | 0.3% | 2.1% | 35 |
| Comparative Example 1 | 47.3 | 18.0% | 17.2% | 3.0% | 4.0% | 70 |
| Comparative Example 2 | 35.7 | 17.0% | 11.5% | 2.5% | 2.8% | 60 |

### Industrial Applicability

The polycrystalline SiC formed body excellent in flatness can be provided as a member for a plasma etching apparatus such as an edge ring, an electrode plate, and a heater, which are used in semiconductor manufacturing.

## Claims

1. A substantially plate-shaped polycrystalline SiC formed body comprising a first main surface and a second main surface parallel to the first main surface,
the polycrystalline SiC formed body including:
along a normal direction to the first main surface,
a region R₂₀₀ in which a (200) plane is oriented,
a region R₃₁₁ in which a (311) plane is oriented,
a region R₁₁₁ in which a (111) plane is oriented, and
a region R₂₂₀ in which a (220) plane is oriented, and
along a normal direction to the second main surface,
a region R₂₀₀ in which a (200) plane is oriented,
a region R₃₁₁ in which a (311) plane is oriented,
a region R₁₁₁ in which a (111) plane is oriented, and
a region R₂₂₀ in which a (220) plane is oriented,
wherein an area fraction of region R_{XYZ}=area of region R_{XYZ}/(area of region R₁₁₁+area of region R₂₀₀+area of region R₂₂₀+area of region R₃₁₁) and region R_{XYZ} is any one of region R₁₁₁, region R₂₀₀, region R₂₂₀, and region R₃₁₁, wherein at least one of a difference between an area fraction of region R₂₀₀ in the first main surface and an area fraction of region R₂₀₀ in the second main surface being 10.0% or less and a difference between an area fraction of region R₃₁₁ in the first main surface and an area fraction of region R₃₁₁ in the second main surface being 10.0% or less is satisfied.

2. The polycrystalline SiC formed body according to claim 1, wherein at least one of a difference between an area fraction of region R₁₁₁ in the first main surface and an area fraction of region R₁₁₁ in the second main surface being 2.0% or less and a difference between an area fraction of region R₂₂₀ in the first main surface and an area fraction of region R₂₂₀ in the second main surface being 2.0% or less is satisfied.

3. The polycrystalline SiC formed body according to claim 1 or 2, wherein an absolute value of BOW is 30 µm or less.

4. A method of producing the polycrystalline SiC formed body according to claim 1, the method comprising forming a polycrystalline SiC layer on a substrate by a CVD method, wherein in forming the polycrystalline SiC layer, crystal growth is controlled so that at least one of a difference in area fraction of the region R₂₀₀ and a difference in area fraction of the region R₃₁₁ between the second main surface in the polycrystalline SiC layer and the first main surface in the polycrystalline SiC layer becomes 10% or less.
